# EUROPEAN PATENT SPECIFICATION

(11) **EP 2 495 492 B1**
(45) Date of publication and mention of the grant of the patent: **10.09.2014**
(21) Application number: 12157943.7
(22) Date of filing: 02.03.2012
(51) Int. Cl.: F21V 23/06, F21V 19/04, F21Y 105/00, F21V 21/02

(54) **Illumination device**
Beleuchtungsvorrichtung
Dispositif d'illumination

(30) Priority: 04.03.2011 JP 2011048127
(43) Date of publication of application: 05.09.2012
(73) Proprietor: Panasonic Corporation, Osaka 571-8501 (JP)
(72) Inventor: Kawachi, Hideharu, Kobe, Hyogo (JP); Miyakawa, Noboru, Moriguchi, Osaka (JP)
(74) Representative: Rüger, Barthelt & Abel

(56) References cited:
- WO-A1-2010/084673
- WO-A1-2010/108906
- JP-A- 2007 172 918
- JP-A- 2007 250 302
- JP-A- 2007 250 303
- JP-A- 2009 129 680
- US-A1- 2006 262 545

## Description

### [Field of the Invention]

The present invention relates to an illumination device using an EL element as a light source.

### [Background Art]

In an electroluminescence (EL) element, a light emitting part constituted by arranging a light emitting layer between a positive electrode and a negative electrode is formed on a transparent substrate. When a voltage is applied between the electrodes, the EL element emits light with an exciton generated by recombination of an electron and a hole, which are injected as carriers into the light emitting layer.

The EL element is broadly classified into an organic EL element including the light emitting layer made of an organic compound and an inorganic EL element including the light emitting layer made of an inorganic compound. In particular, the organic EL element can emit light of high luminance with a low voltage, obtain various luminescent colors depending on the types of the organic compounds and be easily manufactured as a flat light emitting panel. Thus, the organic EL element has recently received attention as a light source for an illumination fixture.

The light emitting panel using the organic EL element has light emission lifetime determined by deterioration of the organic material or the like and thus, the illumination device using this light emitting panel needs to be replaced when the light emitting panel reaches the end of life or is damaged. Therefore, the illumination device using the light emitting panel adopting the organic EL element as the light source is desirably configured so that the light emitting panel can be easily replaced. As this type of illumination device, an illumination device in which a rail-like concave portion is formed on a main body holding the light emitting panel and the light emitting panel is fitted into the concave portion to attach the light emitting panel to the concave portion as well as connect the light emitting panel to a power feeding part provided at the concave portion is known (for example JP2007-172918 A). In this illumination device, the light emitting panel can be attached or detached to or from the concave portion according to a so-called Kendon method.

There is also known an illumination fixture in which a housing having an insertion hole for inserting the light emitting panel thereinto is provided, one end of the housing can be freely rotated with a hinge, and the other end is held, thereby attaching the housing and the light emitting panel inserted into the housing (for example JP 2007-250302 A). This illumination fixture can replace the light emitting panel in the state where the housing is rotated.

### [Conventional Technique Document]

### [Patent Literature]

An illumination device disclosed in WO 2010/084673 A1 comprises a light source part including light emitting panel diodes. The light source part has a case that stores a wiring substrate together with the light emitting panel. An attached part is detachably attached to the light source part and includes a housing providing a power supply for the light emitting panel. Terminal parts for electrically connecting the wiring substrate in the light source part to the housing of the attached part are provided at one side of the light source part. The terminal parts protrude from the wiring substrate. The attached part includes a pair of terminal receiving parts for electrically connection with the terminal parts. An engaging part is provided at one end on the side of a non-light emitting surface of the light source part and an engaged part engaged by the engaging part is provided on the attached part. The light source part can be freely rotated relative to the attached part in the state where the engaging part is engaged with the engaged part. A holding part is provided at a part other than the one end on the side of the non-light emitting surface of the light source part, at which the engaging part is provided and a held part holding the holding part is provided on the attached surface of the attached part.

### [Disclosure of the Invention]

### [Problems to be solved by the Invention]

However, in the illumination device described in JP2007-172918 A, since the concave portion covers a part of the side of a light emitting surface of the light emitting panel, a non-light emitting region (region where no light is emitted) is generated on the light emitting surface. For this reason, for example, when a plurality of light emitting panels are provided, the region of the concave portion becomes non-luminous and thus, the illumination device having a large light emitting surface cannot be assembled. Further, in the illumination fixture described in JP 2007-250302 A, since a part of the housing covers a part of the side of the light emitting surface of the light emitting panel, a non-light emitting region is generated. Furthermore, in this type of illumination device, when attachment of the light emitting panel is simplified, the light emitting panel may be unstably held, and conversely, when the light emitting panel is firmly held, attachment or detachment may become difficult.

The present invention is made in consideration of the above-mentioned problems and its object is to provide an illumination device that can increase a light emitting region on the side of the light emitting surface and easily replace a light source part including the light emitting panel.

### [Means adapted to solve the Problems]

To solve the above-mentioned problems, an illumination device according to claim 1 is proposed. It includes a light source part having a flat light emitting panel, and an attached part detachably attached to the light source part, and in the illumination device, an engaging part is provided at one end on the side of a non-light emitting surface of the light source part, an engaged part engaged with the engaging part is provided on an attached surface of the attached part, to which the light source part is attached, the light source part can be freely rotated relative to the attached part in the state where the engaging part is engaged with the engaged part, a holding part is provided at a part other than the one end on the side of the non-light emitting surface of the light source part, at which the engaging part is provided, and a held part holding the holding part is provided on the attached surface of the attached part.

In the illumination device, it is preferred that the holding part and the held part are provided on a side opposite to the engaging part and the engaged part across a central plane that includes a normal line to the attached surface and a line parallel to a rotating axis about which the light source part can be freely rotated relative to the attached part and passes the center of the light source part.

In the illumination device, the engaging part or the engaged part are provided to be slidable substantially in a direction parallel to the attached surface and is elastically biased from one end toward the center.

In the illumination device, it is preferred that a width of the engaging part and the engaged part is set to be different from a width of the holding part and the held part in the direction of the rotating axis.

In the illumination device, it is preferred that a pair of engaging parts, a pair of engaged parts, a pair of holding parts and a pair of held parts are provided, and spacing between the pair of engaging parts and between the pair of engaged parts is set to be different from spacing between the pair of holding parts and between the pair of held parts.

In the illumination device, it is preferred that the light source part and the attached part each have a power feeding terminal, and the power feeding terminals are located away from the engaging part and the engaged part.

In the illumination device, it is preferred that the holding part and the held part function as power feeding terminals.

In the illumination device, it is preferred that the engaging part and the engaged part function as power feeding terminals.

### [Effect of the Invention]

According to the present invention, since the engaging part and the holding part are provided on the side of the non-light emitting surface of the light source part and the engaged part and the held part are provided on the attached surface of the attached part, they do not cover the side of the light emitting surface of the light source part and therefore, the non-light emitting region on the side of the light emitting surface can be reduced. Moreover, since the light source part can be rotated relative to the attached part to attach or detach the light source part, the light source part including the light emitting panel can be easily replaced.

### [Brief Description of the Drawings]

[Fig. 1] Fig. 1 is an exploded perspective view of an illumination device in accordance with a first embodiment of the present invention.
[Fig. 2] Fig. 2 is a perspective view of a light source part of the illumination device when viewed from an attached part.
[Fig. 3] Fig. 3 is a front view of the light source part of the illumination device when viewed from the attached part.
[Fig. 4] Fig. 4 is a perspective view of the attached part of the illumination device when viewed from the light source.
[Fig. 5] Fig. 5 is a perspective view showing a state where the light source part of the illumination device can be freely rotated relative to the attached part.
[Fig. 6] Figs. 6 (a) to (c) are side sectional views for describing a procedure of attaching the light source part of the illumination device to the attached part.
[Figs. 7 (a) and 7 (b)] Figs. 7 (a) and 7 (b) are alternative embodiments which do not belong to the invention, wherein Fig. 7 (a) is a perspective view showing a state where the light source part of an illumination device in accordance with a second embodiment can be freely rotated relative to the attached part, and Fig. 7 (b) is a perspective view showing a state where the light source part is attached to the attached part.
[Fig. 8] Fig. 8 is an exploded perspective view showing a modification example of the second embodiment which does not belong to the invention.
[Fig. 9] Fig. 9 is an exploded perspective view showing another modification example of the second embodiment which does not belong to the
   invention.

### [Best Mode for Carrying Out the Invention]

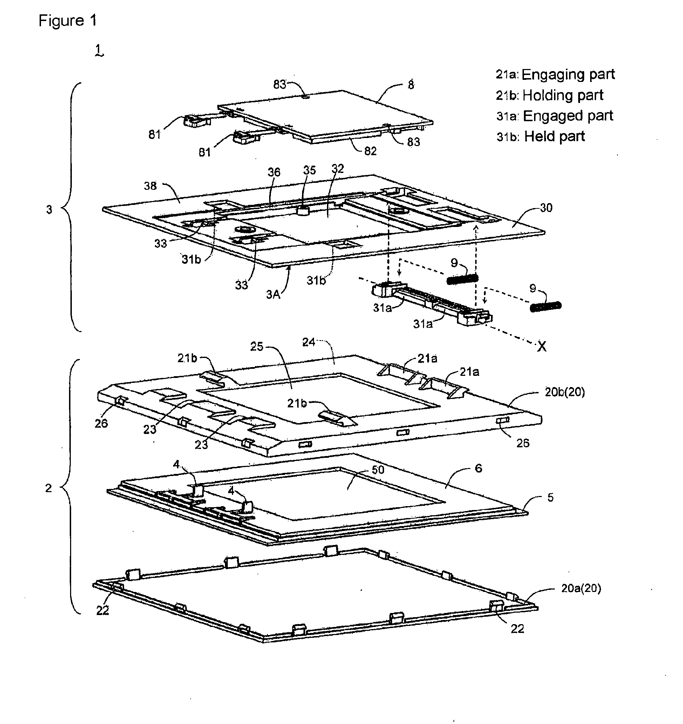

An illumination device in accordance with a first embodiment of the present invention will be described referring to Figs. 1 to 6. As shown in Fig. 1, the illumination device 1 in the present embodiment includes a light source part 2 having a flat light emitting panel 5 using an organic EL element and an attached part 3 that can be detachably attached to the light source part 2. The attached part 3 includes a housing 30 that stores a circuit board 8 for controlling lighting of the light emitting panel 5. A case 20 in the light source part 2 stores a wiring substrate 6 together with the light emitting panel 5. Terminal parts 4 for electrically connecting the wiring substrate 6 in the light source part 2 to the circuit board 8 in the attached part 3 are provided on a surface of the light source part 2, which is opposed to the attached part 3. The terminal parts 4 protrude from the wiring substrate 6 in the light source part 2 and are exposed on the side of the attached part 3 through a grooved part 23 formed on the case 20.

A pair of engaging parts 21a is provided at one end on a side of a non-light emitting surface of the light source part 2, and a pair of engaged parts 31a engaged with the engaging parts 21a are provided on an attached surface 3A of the attached part 3, to which the light source part 2 is attached. In the state where the engaging parts 21a are engaged with the engaged parts 31a, the light source part 2 can be freely rotated relative to the attached part 3. This rotation means that the light source part 2 rotates one end thereof about the other end thereof with respect to the attached part 3. The engaging parts 21a each are shaped like a hook having a front end oriented outward, and the engaged parts 31a are formed to correspond to the engaging parts 21a. The engaging parts 21a and the engaged parts 31a each have a predetermined width, and an engaging section in the width direction of these parts serves as a rotating axis X. In the present embodiment, the engaged parts 31a are slidably attached to the housing 30 and are biased to the center direction of the attached part 3 by biasing mechanisms 9 such as springs. It is preferred that the pair of engaged parts 31a are coupled to each other as shown in the figure. Thereby, the operator can easily slide the pair of engaged parts 31a.

Holding parts 21b are provided at a place other than one end on the side of the non-light emitting surface of the light source part 2, at which the engaging parts 21a are provided, specifically, on the side opposed to the one end, and held parts 31b holding the holding parts 21b are provided on the attached surface 3A of the attached part 3. Like the engaging parts 21a, the holding parts 21b each are shaped like a hook having a front end oriented outward, and the held parts 31b are formed so as to correspond to the shape of the holding parts 21b. The holding parts 21b and the held parts 31b hold the light source part 2 in the attached state to the attached part 3.

The wiring substrate 6 in the light source part 2 is mounted on a non-light emitting surface of the light emitting panel 5. The light emitting panel 5 and the wiring substrate 6 are bonded to each other by means of an acrylic double-sided adhesive tape that includes a core member and is excellent in heat resistance, moisture resistance and stress relief property, and are electrically connected to each other by ultrasonic welding of a power feeding electrode of the light emitting panel 5 described below to a conductive wire (not shown) of the wiring substrate 6.

The case 20 is constituted of a front case 20a covering the side of the light emitting surface (lower side in the figure) of the light emitting panel 5 and a back case 20b covering the side of the non-light emitting surface of the light emitting panel 5. The front case 20a is formed of a transparent rectangular flat plate-like member. The front case 20a may be a rectangular frame-like member having an opened surface opposed to the light emitting panel 5, or a rectangular flat plate-like member having a transparent surface opposed to the light emitting panel 5. In the former case of the front case 20a, it is preferable to arrange a transparent protective cover or the like on the opened region. A plurality of engaging claws 22 to be engaged with the back case 20b are protrudingly provided on the fringe of the front case 20a.

The back case 20b is a closed-end can-like member having an opened surface opposed to the front case 20a, a circumference of its front surface is formed so as to protrude in a direction opposed to the attached part 3, and its back surface constitutes a recessed wiring substrate storing part 24 for storing the wiring substrate 6. The back case 20b also includes a concave portion 25 constituted of a bottom surface except for the wiring substrate storing part 24. In other words, the wiring substrate storing part 24 is formed like a frame having the concave portion 25 at the center thereof.

The above-mentioned engaging parts 21a and the holding parts 21b are formed integrally with the back case 20b on the surface of the wiring substrate storing part 24 on the side of the attached part 3. Engaged grooves 26 engaged with the engaging claws 22 of the front case 20a are provided on a circumferential side surface of the back case 20b. As shown in the figure, it is preferable to partially chamfer a corner part connecting the circumferential side surface of the back case 20b to the wiring substrate storing part 24. Thereby, appearance of the light source part 2 can be made slim. Although the front case 20a and the back case 20b that constitute the case 20 have any shape according to the application of the illumination device 1 and are formed to correspond to the shape of the light emitting panel 5. In the present embodiment, the shape is long rectangle. Examples of a material for the case 20 include plastic materials such as ABS resin, acrylic resin and polystyrene resin, and metal materials such as aluminum having a surface subjected to insulation treatment.

The light emitting panel 5 is obtained by laminating a positive electrode formed of a transparent conductive film, a light emitting layer having a light emitting function and a negative electrode having light reflectance in this order on a rectangular translucent substrate to form a light emitting part (not shown) and coating the outer side of the light emitting part with a sealing member. Materials generally used for the organic EL element are used for the positive electrode, the light emitting layer, the negative electrode and the sealing member as appropriate. A soaking plate 50 such as a copper plate is provided on the sealing member.

The wiring substrate 6 is made of a glass fiber plate obtained by soaking glass fiber cloth with epoxy resin or the like and hardening the soaked cloth, for example, a base material having both incombustibility and low electric conductivity such as FR-4, and is shaped like a frame opened at its center so as to be stored in the wiring substrate storing part 24. The terminal parts 4 each are constituted of a joint piece joined to the wiring substrate 6 or a terminal piece vertically installed on the joint piece. In the present embodiment, the pair of terminal parts 4 is provided on one fringe part of the wiring substrate 6. A positive electrode line and a negative electrode line (not shown) that are electrically connected to the terminal parts 4 are formed on the wiring substrate 6, and these electrode lines are coated with an insulating material and are partially exposed on a surface on the opposite side of a surface opposed to the light emitting panel 5 to form land parts (not shown). The land parts are connected to power feeding electrodes (not shown) electrically connected to the positive electrode and the negative electrode of the light emitting panel 5 with conductive wires, respectively.

The attached part 3 includes a pair of terminal receiving parts 81 for electrically connecting the terminal parts 4 to the circuit board 8, in addition to the housing 30 and the circuit board 8. The housing 30 protrudes toward the light source part 2 to constitute a recessed circuit board storing part 32 for storing the circuit board 8. Through grooves 33 that pass the respective terminal parts 4 therethrough are provided on the housing 30.

The same base material for the wiring substrate 6 as that for the circuit board 8 is used, and various elements 82 such as a driver for driving lighting of the light emitting panel 5 are mounted on the surface of the rectangular base material on the side of the light source part 2. Joined parts to the terminal receiving parts 81 and an external power feeding terminal (not shown) are provided on the circuit board 8, and these joined parts, the external power feeding terminal, the driver and the like are electrically connected according to a wiring pattern formed on the circuit board. The terminal receiving parts 81 are a pair of metal pieces bent in the shape of L, with one end being connected to the circuit board 8, the other end being vertically installed toward the light source part 2 in the shape of a plate spring to hold the terminal parts 4 passing through the through grooves 33 (refer to Fig. 1). This can ensure electrical connection between the terminal receiving parts 81 and the terminal parts 4. The terminal receiving parts 81 may be configured to give a click feeling when being connected to the terminal parts 4. Preferably, the circuit board 8 and the terminal receiving parts 81 are covered with an insulating plate (not shown) from the opposite side to a surface opposed to the light source part 2, thereby being protected against external physical and electrical influences.

The circuit board storing part 32 is located at the center of the attached part 3 so as to be fitted into the concave portion 25 in the light source part 2. A screwed part 35 is provided in the circuit board storing part 32. A holding frame 36 is provided on the fringe of the circuit board storing part 32. The holding frame 36 together with the screwed part 35 holds the circuit board 8 in a floated state so that the various elements 82 mounted on the circuit board 8 may not in contact with a bottom surface of the circuit board storing part 32. A threaded hole 83 is formed on the circuit board 8 at a position corresponding to the screwed part 35 in the circuit board storing part 32. By inserting a screw (not shown) into the threaded hole 83 and the screwed part 35, the circuit board 8 is fixed to the housing 30. Here, the screwed part 35 and the holding frame 36 hold the circuit board 8 so that a surface of the circuit board 8 on which the driver and the like are not mounted (back surface) constitutes a surface that is substantially flat with a fringe part 38. In this manner, when the attached part 3 is attached to an attached plane such as a wall surface, a stable operation can be performed without causing any rattle.

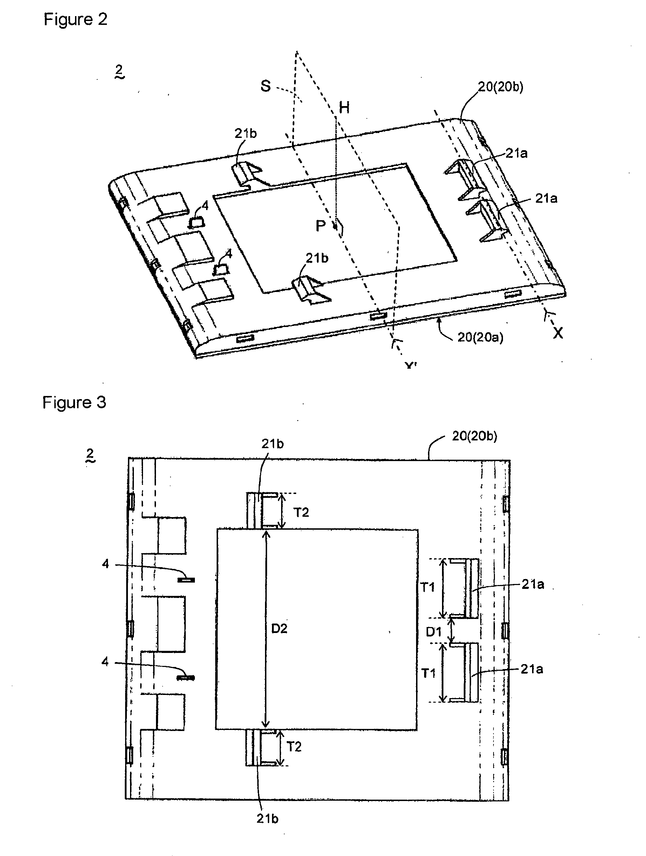

As shown in Fig. 2, the holding parts 21b are provided on the opposite side to the engaging parts 21a across a central plane S of the light source part 2. The central plane S contains a normal line H to the surface opposed to the attached part 3 (or the attached surface 3A (refer to Fig. 1)) and a line X' parallel to the rotating axis X about which the light source part 2 can be freely rotated relative to the attached part 3, and pass a center P of the light source part 2. That is, as shown in the figure, when the engaging parts 21a are provided at the one end of the light source part 2, the holding parts 21b are provided further from the engaging parts 21a than at least the central plane S. By arranging the engaging parts 21a and the holding parts 21b separately from each other in this manner, even when a load is applied to the light source part 2 in the state where the light source part 2 is attached to the attached part 3, a force applied to the engaging parts 21a and the holding parts 21b can be distributed, thereby reducing local stress. Further, flatness of the light source part 2 relative to the attached part 3 is easy to be ensured.

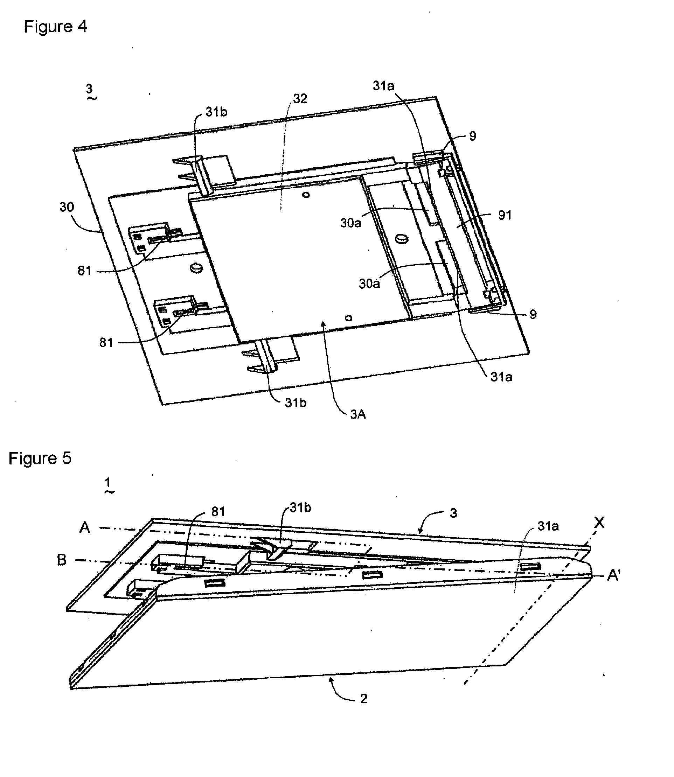

As shown in Fig. 3, each engaging part 21a and each holding part 21b are formed so as to have different widths in the direction of the rotating axis X. In this example, a width T1 of each engaging part 21a is larger than a width T2 of each holding part 21b. The engaged part 31a and the held part 31b are formed so as to correspond to the shape of the engaging part 21a and the holding part 21b, respectively (refer to Fig. 4 described below). With such configuration, since the wide engaging parts 21a cannot be engaged with the narrow held parts 31b, when the light source part 2 is attached to the attached part 3, the light source part 2 can be prevented from being attached in a wrong direction.

The pair of engaging parts 21a and the pair of holding parts 21b are provided so a spacing D1 between the pair of engaging parts 21a is different from a spacing D2 between the pair of holding parts 21b. In the present embodiment, the spacing D1 between the pair of engaging parts 21a is smaller than the spacing D2 between the pair of holding parts 21b. Further, the engaged parts 31a and the held parts 31b are provided at positions corresponding to the engaging parts 21a and the holding parts 21b, respectively. With such configuration, since the pair of holding parts 21b having large spacing therebetween cannot be engaged with the pair of engaged parts 31a having small spacing therebetween, similarly, the light source part 2 can be prevented from being attached in a wrong direction.

As shown in Fig. 4, the above-mentioned engaged parts 31a and held parts 31b are provided on the surface of the housing 30 in the attached part 3, which is opposed to the light source part 2. The engaged parts 31a and the held parts 31b are provided at positions corresponding to the engaging parts 21a and the holding parts 21b, respectively (refer to Fig. 1). Digged parts 30a are formed at positions on the housing 30, which face the engaged parts 31a. The digged parts 30a may be digged down so as to be thinner than other parts of the housing 30 or may penetrate to the back surface of the attached part 3.

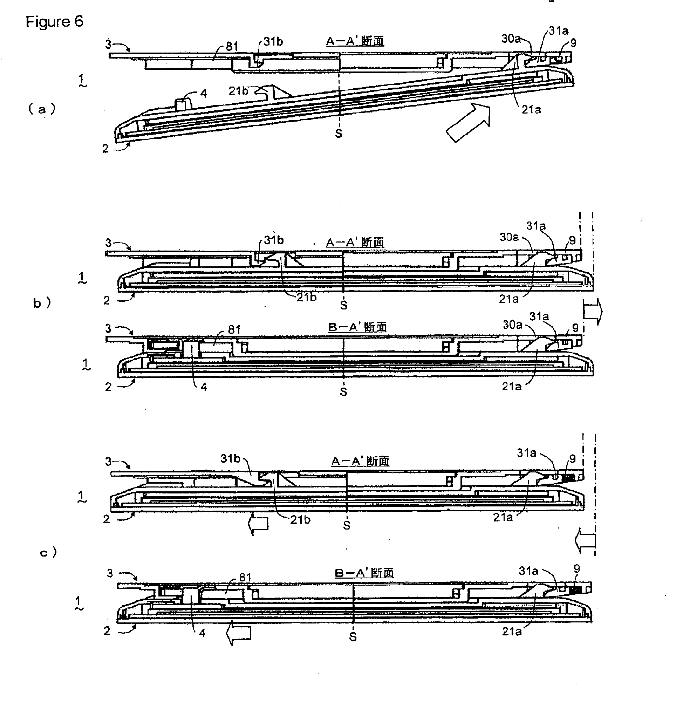

Next, a replacement procedure of the light source part 2 of the illumination device 1 will be described referring to Fig. 5 and Figs. 6(a) to 6(c). A line A-A' in Fig. 5 is a line passing the holding part 21b and the held part 31b, and the engaging part 21a and the engaged part 31a. A line B-A' in Fig. 5 is a line passing the terminal part 4 and the terminal receiving part 81, and the engaging part 21a and the engaged part 31a. Figs. 6(a) to 6(c) show a cross section taken along the line A-A' or a cross section taken along the line B-A' in Fig. 5. In installing the illumination device 1, the attached part 3 may be fixed to a wall surface, a ceiling or an attachment surface (not shown) of the housing constituting the illumination fixture. After that, as shown in Fig. 5 and Fig. 6(a), the light source part 2 is arranged so that terminal parts 4 and the terminal receiving parts 81 are oriented in the same direction, and the light source part 2 is inclined relative to the attached part 3. Then, the light source part 2 is moved so that the engaging parts 21a in the light source part 2 are inserted into the engaged parts 31a in the attached part 3. At this time, since the digged parts 30a are formed on the housing 30 in the attached part 3 at the positions facing the engaged parts 31a, the engaging parts 21a can be deeply inserted into the engaged parts 31a, with the light source part 2 being inclined relative to the attached part 3.

Next, as shown in Fig. 6(b), the light source part 2 is rotated about the rotating axis X so that positional relationship between the light source part 2 and the attached part 3 is changed from the inclined state to the parallel state. At this time, the light source part 2 is rotated while being slid outward by pressing the engaged parts 31a with the engaging parts 21a. Thereby, the holding parts 21b are arranged on the side of the central plane S of the held parts 31b. It is preferred that surfaces of the holding parts 21b on the side of the attached part 3 and surfaces of the held parts 31b on the side of the light source part 2 each are rounded. Thereby, even if the holding parts 21b contact the held parts 31b during rotation of the light source part 2, the holding parts 21b and the held parts 31b slide with respect to each other, so that the holding parts 21b are smoothly arranged on the side of the central plane S of the held parts 31b.

After that, as shown in Fig. 6(c), when the engaged parts 31a are slid toward the central plane S in the state where the light source part 2 is parallel to the attached part 3, the light source part 2 slides and the holding parts 21b are held by the held parts 31b. Here, since the engaged parts 31a is biased by the biasing mechanisms 9 toward the central plane S, when the operator releases pressure to the engaged parts 31a by the engaging parts 21a, the light source part 2 automatically slides and the holding parts 21b is held by the held parts 31b. At this time, due to the elastic force of the biasing mechanisms 9, the operator's feeling of attachment can be improved. Further, at attachment, since the terminal parts 4 are connected to the terminal receiving parts 81, mechanical holding and electrical connection of the light source part 2 and the attached part 3 can be achieved at the same time. As a result, the light source part 2 is attached to the attached part 3 and holding of the light, source part 2 is completed.

Conversely, when the light source part 2 is detached from the attached part 3, the engaged part 31a are slid by grasping the light source part 2 and pressing the light source part 2 to the engaged parts 31a. By doing so, the light source part 2 slightly slides, and the holding parts 21b are detached from the held parts 31b and are not held by the held parts 31b. When an end on the unheld side in the light source part 2 is raised and separated from the attached part 3, the light source part 2 can be easily detached from the attached part 3. In the case where a plurality of illumination devices 1 are arranged in a line, the operator slides the engaged parts 31a with his/her finger, and in the case where the plurality of illumination devices 1 are arranged in a grid manner, the operator slides the engaged parts 31a by inserting a rid-like member into a gap of the illumination devices 1. Thereby, as described above, since the light source part 2 slightly slides, and the holding parts 21b are detached from the held parts 31b and are not held by the held parts 31b, the light source part 2 can be detached from the attached part 3.

In the illumination device 1 in the present embodiment, the terminal parts 4 protrudingly provided in the light source part 2 and the terminal receiving parts 81 in the attached part 3 function as power feeding terminals, and are arranged so as to enable power feeding only when the light source part 2 is attached to the attached part 3. That is, the light source part 2 can feed power when attachment to the attached part 3 is completed, and reliably block power feeding when the light source part 2 is separated from the attached part 3 at detachment. With such configuration, wiring between the light source part 2 and the attached part 3 need not be attached/detached and thus, the light source part 2 and the attached part 3 can be easily attached or detached to or from each other. Moreover, an electrical shock in operations of attaching and detaching the light source part 2 can be prevented.

Since the engaging parts 21a and the holding parts 21b are provided on the side of the non-light emitting surface of the light source part 2, and the engaged parts 31a and the held parts 31b are provided on the attached surface of the attached part 3, these parts do not cover the side of the light emitting surface of the light source part 2 and thus, the non-light emitting region of the light emitting surface can be reduced. Further, since the light source part 2 is rotated relative to the attached part 3 to be attached or detached to or from the attached part 3, the light source part 2 including the light emitting panel 5 can be easily replaced.

Further, the wiring substrate storing part 24 and the circuit board storing part 32 are arranged so that the wiring substrate 6 and the circuit board 8 do not overlap each other and the case 20 in the light source part 2 and the housing 30 in the attached part 3 are engaged with each other. With such configuration, in the state where the light source part 2 is attached to the attached part 3, since both the wiring substrate 6 and the circuit board 8 are arranged on the side of the non-light emitting surface of the light emitting panel 5, the non-light emitting region on the side of the light emitting surface can be reduced. Accordingly, even when the plurality of illumination device 1 are arranged side by side, the light emitting panels 5 can be arranged in close vicinity to each other, enabling assembly of the illumination device having a large light emitting area. Further, since the wiring substrate 6 and the circuit board 8 are arranged so as not to overlap each other, as compared to the case where they overlap each other, the thickness of the illumination device 1 can be made smaller.

Since in the illumination device 1, the light source part 2 including the light emitting panel 5 is separated from the attached part 3 including the circuit board 8, for example, at lighting-off caused by a failure or the end of life of the light emitting panel 5, the user only needs to replace only the light source part 2.

In a modification example of the present embodiment, for example, the terminal parts 4 in the light source part 2 may be integrated into the holding parts 21b, and the terminal receiving parts 81 in the attached part 3 may be integrated into the held parts 31b. That is, the terminal parts 4 are connected to the terminal receiving parts 81 in the state where the holding parts 21b are held by the held parts 31b. In this modification example, as in the first embodiment, mechanical holding and electrical connection of the light source part 2 and the attached part 3 can be achieved at the same time. The light source part 2 may be distributed as a replacement member. In order to prevent damage such as bending in this distribution stage, the terminal parts 4 protrudingly provided in the light source part 2 need to be protected. However, in this modification example, since the terminal parts 4 are integrated into the holding parts 21b as structural members, the terminal parts 4 can be protected without using a separate protective member. Further, the holding parts 21b and the held parts 31b each are made of a conductive material, and the parts themselves may function as power feeding terminals. In this manner, the number of components can be reduced.

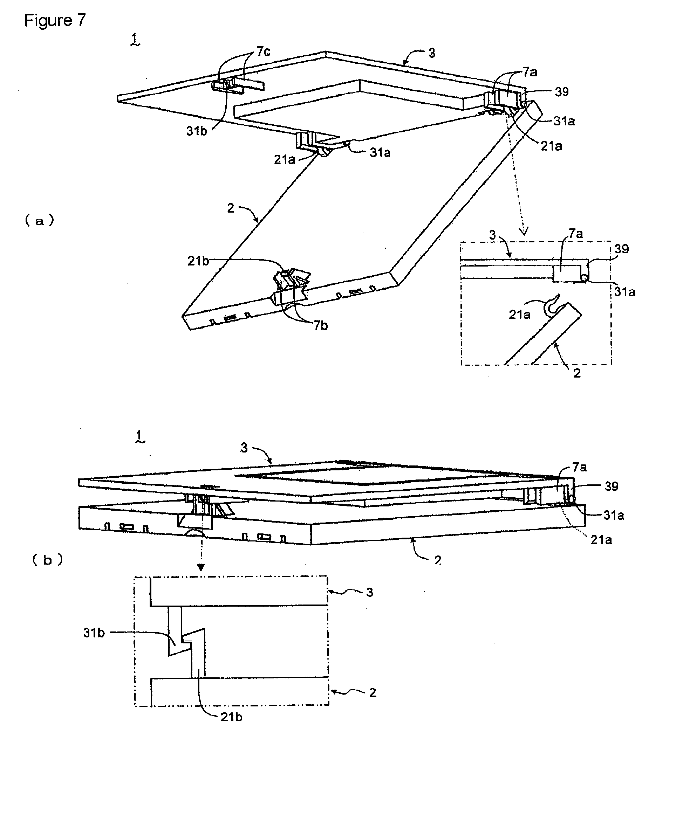

Next, an illumination device in accordance with an alternative second embodiment, which does not belong to the present invention, will be described referring to Figs. 7(a) and 7(b). In the illumination device 1 in accordance with the present embodiment, the engaging parts 21a in the light source part 2 each are formed as a U-like hook member and the engaged parts 31a in the attached part 3 each are formed as a shaft member. That is, the U-like engaging parts 21a are caught by the shaft-like engaged parts 31a, resulting in that the light source part 2 can be freely rotated relative to the attached part 3 using the engaged parts 31a as rotating axes. In this example, two engaging parts 21a and two engaged parts 31a are provided at both ends of a side of the light source part 2 and both ends of a side the attached part 3, respectively. The holding part 21b and the held part 31b are provided on sides opposed to the sides where the engaging parts 21a and the engaged parts 31a are provided. In this example, one light source part 2 and one attached part 3 are provided at the center of the above-mentioned sides.

The engaging parts 21a each are made of a metal material having predetermined stiffness and conductivity Spacing between both ends of the U-like engaging part 21a is larger than a diameter of the shaft member of the engaged part 31a. One end of the U-like engaging part 21a is fixed to the light source part 2 and is electrically connected to a wiring board (not shown) stored in the light source part 2. It is preferred that an intermediate part of the engaging part 21a is shaped like a U-like arc of 180 degrees or larger. Thus, in a predetermined range of the rotation angle of the light source part 2 relative to the attached part 3, engagement of the engaging parts 21a with the engaged parts 31a is hard to be released. The other end of the U-like engaging part 21a, as shown in an enlarged view of Fig. 7(a), is slightly bent to the opposite side to the U-like arc. Thereby, this end is easy to hang on the shaft part of the engaged part 31a and to be detached from there.

The engaged parts 31a each are made of a metal material having predetermined stiffness and conductivity. Each engaged parts 31a is axially supported by a pair of shaft bearing pieces 39 protruding from the attached part 3 toward the light source part 2. A wiring (not shown) for electrically connecting a circuit board (not shown) stored in the attached part 3 to the engaged parts 31a is integrated into the shaft bearing piece 39. Accordingly, by engaging the engaging parts 21a with the engaged parts 31a, the light source part 2 is electrically connected to the attached part 3. A pair of spacing holding members 7a for holding spacing between the light source part 2 and the attached part 3 and their rotating angle to be constant is provided on the inner side of the shaft bearing piece 39.

As shown in an enlarged view of Fig. 7(b), the holding part 21b and the held part 31b each are an L-like plate member, and their bent front ends are engaged with each other, thereby holding the light source part 2 at the attached part 3. At least one of the holding part 21b and the held part 31b is made of an elastic material and is elastically deformed, so that a front end of one of the holding part 21b and the held part 31b is fitted into a bent part of the other, which achieves engagement. Like the shaft bearing pieces 39, a pair of spacing holding members 7b, 7c for holding spacing between the light source part 2 and the attached part 3 and their rotating angle to be constant is provided on the outer side of the holding part 21b and the held part 31b, respectively. In this example, the spacing holding members 7b in the light source part 2 are arranged inward and the spacing holding members 7c in the attached part 3 are arranged outward so that the spacing holding members 7b do not contact the spacing holding members 7c.

In the present embodiment, since mechanical holding and electrical connection of the light source part 2 and the attached part 3 can be achieved with a simple configuration, the number of components can be reduced and productivity of the illumination device 1 can be improved.

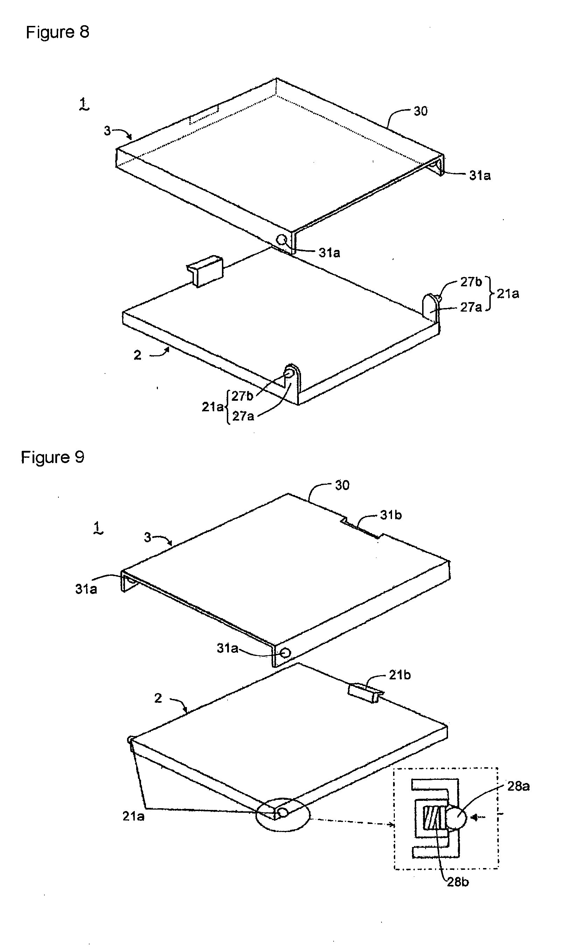

Next, modification examples of the present embodiment will be described referring to Figs. 8 and 9. In the modification example shown in Fig. 8, the engaging parts 21a in the light source part 2 each are constituted of a vertically installed piece 27a vertically installed on the side of the attached part 3 and a protruding part 27b provided on an outer side surface of the vertically installed piece 27a, and the engaged parts 31a in the attached part 3 each are a constituted a hole part formed on the side surface of the housing 30 in the attached part 3. The vertically installed piece 27a is formed of an elastic member, and the protruding parts 27b of the engaging parts 21a are fitted into the corresponding hole parts of the engaged parts 31a, so that the engaging parts 21a are engaged with the engaged parts 31a and the light source part 2 can be rotated relative to the attached part 3. The holding part 21b is formed of an L-like plate member as in the above-mentioned embodiment. The held part 31b is constituted of a grooved part formed on the side surface of the housing 30 in the attached part 3. With such configuration, a bent front end of the holding part 21b is fitted into the grooved part of the held part 31b, so that the holding part 21b is engaged with the held parts 31b and the light source part 2 is mechanically held by the attached part 3.

In the modification example shown in Fig. 9, the engaging parts 21a in the light source part 2 each are constituted of a protruding part 28a that can freely appear and is formed on the side surface of the case 20 in the light source part 2, and the engaged parts 31a of the attached part 3 each are constituted of a hole part formed on the side surface of the housing 30 in the attached part 3. The protruding part 28a is biased to protrude from the case 20 by a spring 28b. In this example, the inner circumferential surface of the housing 30 is larger than the outer circumferential surface of the case 20. With such configuration, the protruding parts 28a of the engaging parts 21a are fitted into the hole parts of the engaged parts 31a, so that the engaging parts 21a are engaged with the engaged parts 31a, and the light source part 2 can be rotated relatively to the attached part 3. The holding part 21b and the held part 31b have the same configuration as that in the above-mentioned modification example, and the bent front end of the holding part 21b is fitted into the grooved part of the held part 31b, so that the holding parts 21b is engaged with the held parts 31b and the source part 2 is mechanically held by the attached part 3. In these modification examples, mechanical holding and electrical connection of the light source part 2 and the attached part 3 can be achieved with a simpler configuration.

As long as the light source part 2 can be freely rotated relative to the attached part 3 by engaging the engaging parts 21a with the engaged parts 31a, and the light source part 2 and the attached part 3 are held by the holding part 21b and the held part 31b, the present invention is not limited to the above-mentioned embodiments, and can be variously modified. For example, although the engaged parts 31a are configured to be slidable in the above-mentioned embodiments, the engaging parts 21a may be configured to be slidable.

### [Description of Reference Numerals]

- 1: Illumination device
- 2: Light source part
- 20: Case
- 21a: Engaging part
- 21b: Holding part
- 3: Attached part
- 3A: Attached surface
- 31a: Engaged part
- 31b: Held part
- 4: Terminal part (power feeding terminal)
- 81: Terminal receiving part (power feeding terminal)
- H: Normal line
- P: Center of light source part
- S: Central plane
- X: Rotating axis

## Claims

1. An illumination device comprising:
a light source part (2) including a flat light emitting panel (5) with an organic EL element;
the light source part (2) having a case (20) that stores a wiring substrate (6) together with the light emitting panel (5);
an attached part (3) detachably attached to the light source part (2);
the attached part (3) includes a housing (30) that stores a circuit board (8) for controlling lighting of the light emitting panel (5),
wherein:
terminal parts (4) for electrically connecting the wiring substrate (6) in the light source part (2) to the circuit board (8) in the attached part (3) are provided on a surface of the light source part (2), which is opposed to the attached part (3), the terminal parts (4) protrude from the wiring substrate (6) in the light source part (2) and are exposed on the side of the attached part (3) through a grooved part (23) formed on the case (20);
the attached part (3) includes a pair of terminal receiving parts (81) for electrically connecting the terminal parts (4) to the circuit board (8)_{,} through grooves (33) that allow the respective terminal parts (4) to pass through the housing (30) are provided on the housing (30);
an engaging part (21a) is provided at one end on the side of a non-light emitting surface of the light source part (2);
an engaged part (31a) engaged with the engaging part (21a) is provided on an attached surface of the attached part (3), to which the light source part (2) is attached;
the light source part (2) can be freely rotated relative to the attached part (3) in the state where the engaging part (21a) is engaged with the engaged part (31a);
the engaging part (21a) or the engaged part (31a) is provided to be slidable substantially in a direction parallel to the attached surface and is elastically biased toward a center direction of the attached part (3);
a holding part (21b) is provided at a part other than the one end on the side of the non-light emitting surface of the light source part (2), at which the engaging part (21a) is provided; and
a held part (31b) holding the holding part (21a) is provided on the attached surface of the attached part (3).

2. The illumination device according to claim 1, wherein
the holding part (21b) and the held part (31b) are provided on a side opposite to the engaging part (21a) and the engaged part (31a) across a central plane (S) that includes a normal line (H) to the attached surface and a line parallel to a rotating axis (X) about which the light source part (2) can be freely rotated relative to the attached part (3) and passes the center (P) of the light source part (2).

3. The illumination device according to any one claim 1 to claim 2, wherein
a width (T1) of the engaging part (21a) and the engaged part (31a) is set to be different from a width (T2) of the holding part (21b) and the held part (31b) in the direction of the rotating axis (X).

4. The illumination device according to any on claim 1 to claim 3, wherein
a pair of engaging parts (21a), a pair of engaged parts (31a), a pair of holding parts (21b) and a pair of held parts (31b) are provided, and spacing (D1) between the pair of engaging parts (21a) and between the pair of engaged parts (31a) is set to be different from spacing (D2) between the pair of holding parts (21b) and between the pair of held parts(31b).

5. The illumination device according to any on claim 1 to claim 4, wherein
the light source part (2) and the attached part (3) each have a power feeding terminal (4, 81), and the power feeding terminals (4, 81) are located away from the engaging part (21a) and the engaged part (31a).

6. The illumination device according to any on claim 1 to claim 4, wherein
the holding part (21b) and the held part (31b) function as power feeding terminals (4, 81).

7. The illumination device according to any on claim 1 to claim 4, wherein
the engaging part (21a) and the engaged part (31a) function as power feeding terminals (4, 81).

## Patentansprüche

1. Beleuchtungsvorrichtung aufweisend:
ein Lichtquellenteil (2) enthaltend ein flaches Lichtemissionspanel (5) mit einem organischen Elektrolumineszenzelement;
wobei das Lichtquellenteil (2) ein Gehäuse (2) aufweist, das ein Leitungsträger (6) zusammen mit dem Lichtemissionspanel (5) aufnimmt;
ein Befestigungsteil (3), das lösbar an dem Lichtquellenteil (2) befestigt ist;
wobei das Befestigungsteil (3) ein Gehäuse (30) aufweist, das eine Leiterplatte (8) zur Steuerung der Lichtabgabe des Lichtemissionspanels (5) aufnimmt, wobei:
Anschlussteile (4) zur elektrischen Verbindung des Leitungsträgers (6) in dem Lichtquellenteil (2) mit der Leiterplatte (8) in dem Befestigungsteil (3) an einer Fläche des Lichtquellenteils (2) vorhanden sind, die dem Befestigungsteil (3) entgegengesetzt ist, wobei die Anschlussteile (4) von dem Leitungsträger (6) in dem Lichtquellenteil (2) vorstehen und von der Seite des Befestigungsteils (3) durch ein ausgespartes Teil (23) zugänglich sind, das an dem Gehäuse (20) gebildet ist;
das Befestigungsteil (3) ein Paar von Anschlussaufnahmeteilen (81) zur elektrischen Verbindung der Anschlussteile (4) mit der Leiterplatte (8) enthält, wobei Durchgangsaussparungen (33) an dem Gehäuse (30) vorhanden sind, die es den betreffenden Anschlussteilen (4) ermöglichen, das Gehäuse (30) zu durchsetzen;
ein Beaufschlagungsteil (21a) an einem Ende der Seite einer nicht lichtemittierenden Fläche des Lichtquellenteils (2) vorhanden ist;
ein beaufschlagtes Teil (31a), das in Eingriff steht mit dem Beaufschlagungsteil (21a), an einer Befestigungsfläche des Befestigungsteils (3) vorhanden ist, an der das Lichtquellenteil (2) befestig ist;
das Lichtquellenteil (2) gegenüber dem Befestigungsteil (3) in dem Zustand, in dem das Beaufschlagungsteil (21a) mit dem beaufschlagten Teil (31a) in Eingriff steht, frei gedreht werden kann;
das Beaufschlagungsteil (21a) oder das beaufschlagte Teil (31a) im Wesentlichen in einer Richtung parallel zu der Befestigungsfläche verschiebbar und elastisch zu einer Zentrumsrichtung des Befestigungsteils (3) vorgespannt ist;
ein Halteteil (21b) ist an einem Teil angeordnet, das verschieden ist von dem einen Ende an der Seite der nicht lichtemittierenden Fläche des Lichtquellenteils (2), an dem das Beaufschlagungsteil (21a) vorhanden ist; und
ein gehaltenes Teil (31b), das das Halteteil (21a) hält, an der Befestigungsfläche des Befestigungsteils (3) vorhanden ist.

2. Beleuchtungsvorrichtung nach Anspruch 1, wobei das Halteteil (21b) und das gehaltene Teile (31b) an einer Seite gegenüberliegend zu dem Beaufschlagungsteil (21a) und dem beaufschlagten Teil (31a) bezogen auf eine zentrale Ebene (S) angeordnet sind, die eine Normalenlinie (H) auf die Anbringungsfläche und eine Linie parallel zur Drehachse (X) aufweist, um die das Lichtquellenteil (2) frei gegenüber dem Befestigungsteil (3) gedreht werden kann, und die durch das Zentrum (P) des Lichtquellenteils (2) verläuft.

3. Beleuchtungsvorrichtung nach einem der Ansprüche 1 oder 2, wobei eine Breite (T1) des Beaufschlagungsteils (21a) und des beaufschlagten Teils (31a) verschieden vorgegeben ist von einer Breite (T2) des Halteteils (21b) und des gehaltenen Teils (31b) in Richtung der Drehachse (X).

4. Beleuchtungsvorrichtung nach einem der Ansprüche 1 bis 3, wobei
ein Paar von Beaufschlagungsteilen (21a), ein Paar von beaufschlagten Teilen (31a), ein Paar von Halteteilen (21b) und ein Paar von gehaltenen Teilen (31b) vorhanden sind und der Abstand (D1) zwischen dem Paar von Beaufschlagungsteilen (21a) und zwischen dem Paar von beaufschlagten Teilen (31a) verschieden vorgegeben ist von dem Abstand (D2) zwischen dem Paar von Halteteilen (21b) und zwischen dem Paar von gehaltenen Teilen (31b).

5. Beleuchtungsvorrichtung nach einem der Ansprüche 1 bis 4, wobei
das Lichtquellenteil (2) und das Befestigungsteil (3) jeweils einen Energiezufuhranschluss (4, 81) aufweisen, und wobei die Energiezufuhranschlüsse (4, 81) beabstandet von dem Beaufschlagungsteil (21a) und dem beaufschlagten Teil (31a) angeordnet sind.

6. Beleuchtungsvorrichtung nach einem der Ansprüche 1 bis 4, wobei
das Halteteil (21b) und das gehaltene Teil (31b) als Energiezufuhranschlüsse (4, 81) arbeiten.

7. Beleuchtungsvorrichtung nach einem der Ansprüche 1 bis 4, wobei
das Beaufschlagungsteil (21a) und das beaufschlagte Teil (31a) als Energiezufuhranschlüsse (4, 81) arbeiten.

## Revendications

1. Dispositif d'éclairage comprenant :
une partie formant source de lumière (2) comprenant un panneau plat émettant de la lumière (5) pourvu d'un élément électroluminescent organique ;
la partie formant source de lumière (2) comportant une enveloppe (20) qui contient un substrat de câblage (6) ainsi que le panneau émettant de la lumière (5) ;
une partie attachée (3) fixée de manière détachable à la partie formant source de lumière (2) ;
la partie attachée (3) comprend un boîtier (30) qui contient une carte de circuit imprimé (8) pour commander l'allumage du panneau émettant de la lumière (5), dans lequel :
des parties terminales (4) pour connecter électriquement le substrat de câblage (6) présent dans la partie formant source de lumière (2) à la carte de circuit imprimé (8) présente dans la partie attachée (3) sont prévues sur une surface de la partie formant source de lumière (2) qui est opposée à la partie attachée (3), les parties terminales (4) faisant saillie du substrat de câblage (6) présent dans la partie formant source de lumière (2) et étant exposées sur le côté de la partie attachée (3) à travers une partie rainurée (23) formée sur l'enveloppe (20) ;
la partie attachée (3) comprend une paire de parties réceptrices terminales (81) pour connecter électriquement les parties terminales (4) à la carte de circuit imprimé (8), à travers des rainures (33) qui permettent aux parties terminales respectives (4) de passer à travers le boîtier (30) et qui sont prévues sur le boîtier (30) ;
une partie de mise en prise (21a) est prévue à une extrémité du côté d'une surface de la partie formant source de lumière (2) qui n'émet pas de lumière ;
une partie engagée (31a) en prise avec la partie de mise en prise (21a) est prévue sur la surface attachée de la partie attachée (3), sur laquelle est fixée la partie formant source de lumière (2) ;
la partie formant source de lumière (2) peut tourner librement par rapport à la partie attachée (3) dans l'état où la partie de mise en prise (21a) est en prise avec la partie engagée (31a) ;
la partie de mise en prise (21a) ou la partie engagée (31a) est prévue pour pouvoir glisser substantiellement dans une direction parallèle à la surface attachée et est poussée de façon élastique vers une direction centrale de la partie attachée (3) ;
une partie de maintien (21b) est prévue dans une partie autre que la première extrémité du côté de la surface de la partie formant source de lumière (2) qui n'émet pas de lumière, au niveau de laquelle est placée la partie de mise en prise (21a) ; et
une partie maintenue (31b) qui tient la partie de maintien (21a) est prévue sur la surface attachée de la partie attachée (3).

2. Dispositif d'éclairage selon la revendication 1, dans lequel la partie de maintien (21b) et la partie maintenue (31b) sont prévues sur un côté opposé à la partie de mise en prise (21a) et la partie engagée (31a) à travers un plan central (S) qui comprend une ligne normale (H) à la surface attachée et une ligne parallèle à un axe de rotation (X) autour duquel la partie formant source de lumière (2) peut tourner librement par rapport à la partie attachée (3) et qui passe par le centre (P) de la partie formant source de lumière (2).

3. Dispositif d'éclairage selon l'une quelconque des revendications 1 à 2, dans lequel la largeur (T1) de la partie de mise en prise (21a) et de la partie engagée (31a) est différente de la largeur (T2) de la partie de maintien (21b) et de la partie maintenue (31b) dans la direction de l'axe de rotation (X).

4. Dispositif d'éclairage selon l'une quelconque des revendications 1 à 3, dans lequel une paire de parties de mise en prise (21a), une paire de parties engagées (31a), une paire de parties de maintien (21b) et une paire de parties maintenues (31b) sont prévues, et l'espacement (D1) entre les deux parties de mise en prise (21a) et entre les deux parties engagées (31a) est différent de l'espacement (D2) entre les deux parties de maintien (21b) et entre les deux parties maintenues (31b).

5. Dispositif d'éclairage selon l'une quelconque des revendications 1 à 4, dans lequel la partie formant source de lumière (2) et la partie attachée (3) comportent chacune une borne d'alimentation électrique (4, 81), et les bornes d'alimentation électrique (4, 81) sont éloignées de la partie de mise en prise (21a) et de la partie engagée (31a).

6. Dispositif d'éclairage selon l'une quelconque des revendications 1 à 4, dans lequel la partie de maintien (21b) et la partie maintenue (31 b) fonctionnent comme des bornes d'alimentation électrique (4, 81).

7. Dispositif d'éclairage selon l'une quelconque des revendications 1 à 4, dans lequel la partie de mise en prise (21a) et la partie engagée (31a) fonctionnent comme des bornes d'alimentation électrique (4, 81).
